Europäisches Patentamt

European Patent Office

Office européen des brevets

(11) Publication number: 0 219 962
A1

## (12) EUROPEAN PATENT APPLICATION

(21) Application number: 86306926.6

(22) Date of filing: 09.09.86

(51) Int. Cl.4: G01R 23/15

(30) Priority: 09.09.85 US 773562

(43) Date of publication of application:
29.04.87 Bulletin 87/18

(84) Designated Contracting States:
AT BE CH DE FR GB IT LI LU NL SE

(71) Applicant: SOUTHERN CALIFORNIA EDISON
COMPANY
2244 Walnut Grove Avenue
Rosemead California 91770(US)

(72) Inventor: Valdes, Oliver Joe
205 North Baymar Avenue
West Covina California 91791(US)
Inventor: Head, Joe
1629 South Third Avenue
Arcadia California 91006(US)
Inventor: Miller, John Joel
6581 Trask Avenue
Westminster California 92683(US)

(74) Representative: Orchard, Oliver John
JOHN ORCHARD & CO. Staple Inn Buildings
North High Holborn
London WC1V 7PZ(GB)

(54) Improved line frequency monitor.

(57) The input line signal is input to a standard power transformer to reduce its voltage, and a Schmitt trigger is connected to the secondary of the power transformer. The Schmitt trigger detects the zero-crossing of the line signal voltage's AC waveform, producing a square-wave output representative of the input signal. This square-wave output is sampled by a microprocessor, driven at approximately 2.0 MHz, which measures the number of 2.0 MHz timing between the leading edges of each period of the square-wave signal, calculates the average line signal frequency, and notes the time of day as appropriate. Line signal voltage measurements can also be monitored. Keyboard input is provided for instructing the microprocessor with new averaging and measurement parameters. An alarm signals deviations beyond preset limits of frequency.

Fig. 1.

## IMPROVED LINE FREQUENCY MONITOR

The present invention relates to the field of electric power systems. More specifically, it relates to the field of electric utility power system line frequency monitors. Additionally the electric utility voltage may also be monitored.

An important aspect of electric power systems is the frequency of the power signal which is output to the electric power grid (the "line signal frequency"). Detailed records are generally maintained by utility power generation companies of the amplitude, frequency, and other signal characteristics of the power signal which they produce. For ease of management, it is often desirable to provide a summary indicator of line frequency conditions for the past day. Examples of desirable indicators include the present output frequency, the minimum and maximum output frequency for the past day and the times when those minimum and maximum output frequencies were recorded.

It is particularly important to measure the frequency of the utility power signal to great accuracy. Deviations of as little as 0.015 Hz can be considered critical by utility power generation companies. These can also be difficult to measure due to the relative low-frequency of the power line signal.

Although it is known in the prior art to measure signal frequency, it is especially important in some applications (eg the management of electric power systems) to record the measurements and to make the record available for later perusal by a manager. One method of the prior art is for the manager who wishes to keep track of recent events to call his engineering supervisor and ask for the necessary performance statistics for the previous twenty-four hours. The engineering supervisor must then review the detailed records by hand, looking for the minimum and maximum output frequency, and report these data items to his manager. While this method of the prior art accomplishes its objective - that of obtaining the necessary information for the facility manager, it is subject to two major drawbacks. First, it may require repeated interruptions of the engineering supervisor's time; second, it may also require difficult manual perusal of the line signal frequency records.

Although it is known in the prior art to measure signal frequency, most methods of the prior art are directed to (and primarily effective at) measurement of relatively high frequency signals.

Therefore it is an object of the invention to provide an improved method and device for monitoring line signal frequency.

It is a second object of the invention to provide an improved method and device for recording the minimum and maximum line signal frequency for the past twenty-four hours, and the times they were recorded.

It is yet a third object of the invention to provide an improved method and device for producing a printed copy of this same information.

Moreover, the invention is also directed to monitoring the line signal voltage at the electrical convenience outlet.

These and other objects of the present invention will become clear after an examination of the drawings, the description, and the claims herein.

The input line signal is input to a standard power transformer to reduce its voltage, and a Schmitt trigger circuit is connected to the secondary of the power transformer. The Schmitt trigger circuit detects the zero-crossing of the line signal voltage's AC waveform, producing a square-wave output representative of the input signal. This square-wave output is sampled by a microprocessor driven at approximately 2.0 MHz, which measures the square-wave's width by counting the number of 2.0 MHz pulses in each period of the square-wave signal, calculates the average line signal frequency, and notes the time of day as appropriate. Keyboard input is provided for instructing the microprocessor with new averaging and measurement parameters if necessary.

The microprocessor records the high value and the low value for measured frequency for the past twenty-four hours. It continuously displays this information to the operator, updating the information as needed.

The microprocessor additionally records voltage values, and frequency and voltage values and other information is recorded on printed matter. Alternatively or additionally this information can be obtained instantaneously from non-recorded data by appropriate key-pad entry.

An embodiment of the invention will be described by way of example only and with reference to the accompanying drawings.

FIGURE 1 is a block diagram of the invention, and,

FIGURE 2 is a circuit diagram of the power supply.

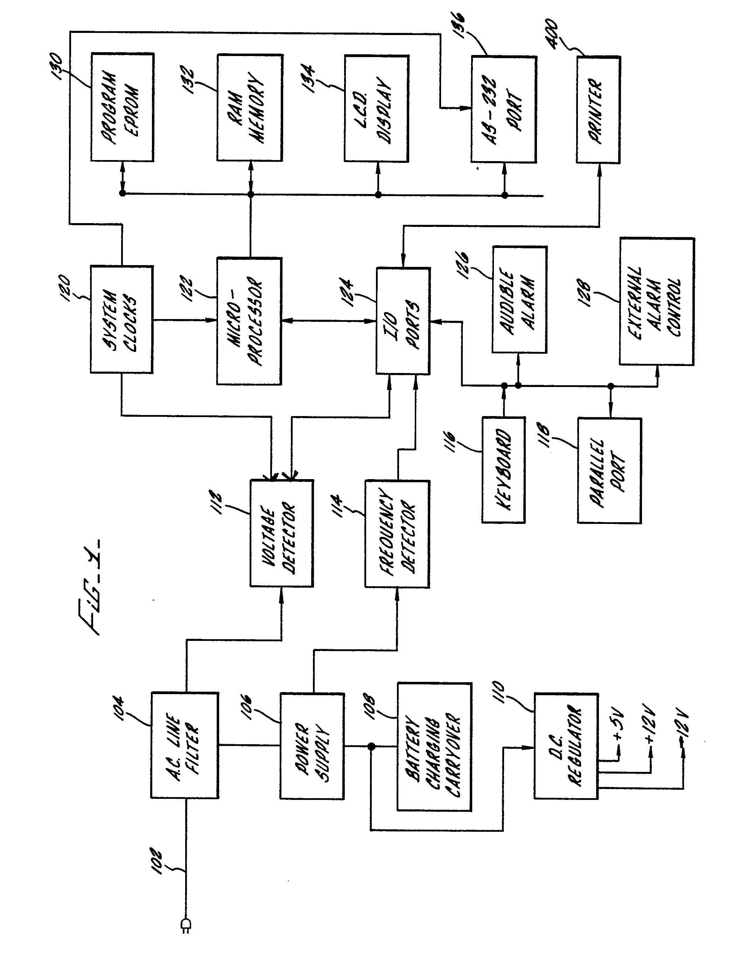

Referring now to Figure 1, the block structure of the invention is disclosed.

Signal Output

The line signal 102 is input to a line signal input filter 104 to suppress high frequency spikes or voltage surges. These spikes or surges, if allowed to enter the circuitry without filtering, could result in erroneous frequency readings or even damage the frequency monitor. The input filter may comprise an inductor-capacitor network, as is well-known in the art. An 0.1 amp fuse of any standard type is used to protect against over currents and short circuits.

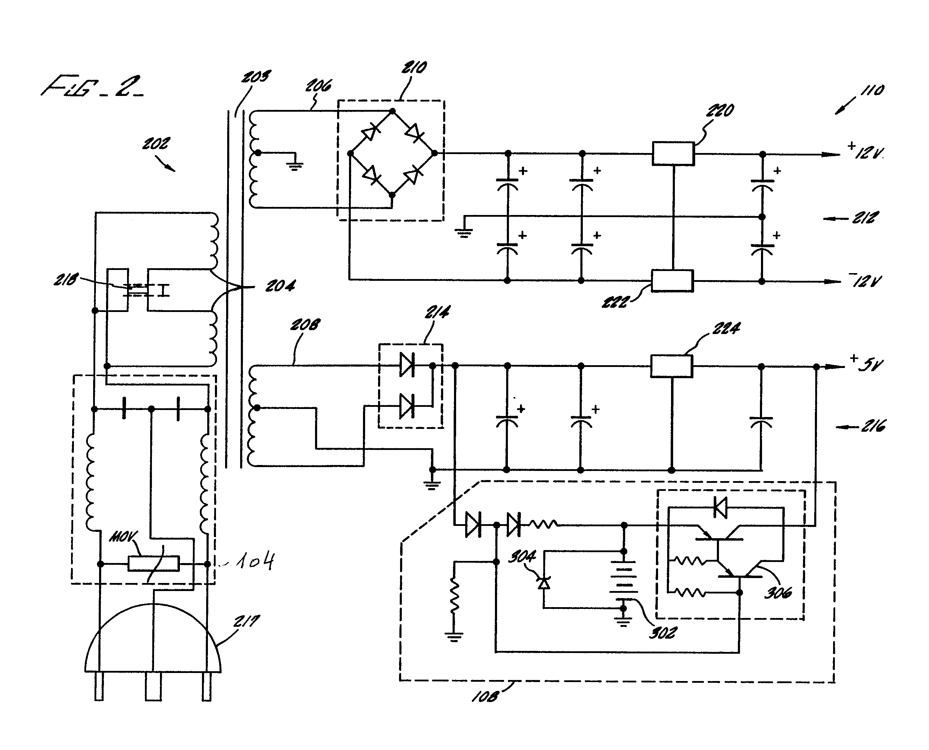

The signal from the input filter 104 is drawn to a power supply 106, which steps down the input voltage from the anticipated 120 or 240 volt AC as selected by a switch (shown in Fig. 2), creating a 12 volt AC and a 24 volt AC signal. This part of the power supply may comprise a power transformer of any standard type. These reduced voltage signals are rectified to produce a +12 volt DC, -12 volt DC, and a +5 volt DC supply to support the battery charger 108 and to source the voltage regulators 110. Three voltage regulators 110, at +5 volts DC, +12 volts DC, and -12 volts DC, are provided to supply power to the digital circuitry.

The battery charger 108 may comprise a battery charging circuit to trickle charge a 6.0 volt battery source; the battery source is provided to maintain the DC power to the circuitry during any AC power outages which may occur. AC power outages are detected by a transistor circuit, which switches in battery power when AC power is lost. The charging current is supplied through a current-limiting resistor and a zener diode across the battery to maintain the battery at a proper charge level,as is well known in the art.

Signal Measurement

The signal from the input filter 104 is also drawn to a voltage detector 112, which converts the filtered input signal from analog to digital. The voltage detector may comprise an analog-to-digital converter of any standard type. The digital voltage signal is drawn to an I/O port 124 for input to a programmed microprocessor 122.

The reduced voltage signals from the power supply 106 are drawn to a frequency detector 114, which converts the sine-wave AC input to a square-wave output. A Schmitt-trigger circuit is used to detect the zero-crossing of the line signal voltage's AC waveform, producing a square-wave output representative of the input signal. This square-wave output is also drawn to an I/O port 124 for input to a programmed microprocessor 122. The microprocessor will sample this signal to measure the square-wave's period and calculate the average line signal frequency: It counts the number of 2.0 MHz timing pulses in each period of the square-wave signal (starting with the leading edge of the square-wave) and averages these counts over a period of 4 to 60 cycles, as selected by an operator-settable stored parameter.

An 8-bit programmed microprocessor 122 running at a clock speed of about 2.0 MHz is used to sample the square-wave signal from the frequency detector 114. A system clock 120, which may comprise two digital clock circuits of any standard type to produce a 2.0 MHz, 1.843 MHz, and a 320 KHz signal, is us ed to clock the microprocessor and to synchronise it with other digital circuitry, including the voltage detector 112 and the RS-232 port 136. The microprocessor detects the square-wave signal, as well as the digitised voltage value, from its I/O ports 124; it performs all frequency calculations, stores all values to be recorded, and controls all its peripheral devices including, eg, a continuous display and a hard copy printer device. The microprocessor at all times operated under control of software which is stored in an 8 kilobyte program EPROM (erasable-programmable read-only memory) 130, using approximately 8 kilobytes of RAM memory 132 for storage of intermediate values. These memories may comprise suitable digital memories of any standard types.

In addition to monitoring the frequency the microprocessor 122 through the voltage detector 112 and I/O ports 124 can monitor the voltage at convenience outlet. The voltage detector already digitises the voltage value from the input AC line filter 104. This digitalised value is then processed by the microprocessor 122 and monitored. The monitored voltage can be displayed on the L.C.D. display 134.

A hard copy printer device 400 is connected through the I/O ports 124 and so that monitored frequency values and monitored voltage values can be permanently recorded.

The audible alarm 126 and external alarm control 128 can be made responsive to preset voltage values in addition to the frequency values.

External connectors

The keyboard 116 is provided to allow an operator of the line frequency monitor to enter data, parameters, and instructions for the programmable microprocessor 122. The keyboard input can be for entering frequency information and in addition voltage information. It may comprise a 16 key keyboard of any standard type.

A parallel port 118 may be provided to allow parallel data communications with external devices not included in the basic design. It may comprise a digital parallel port of any standard type.

The audible alarm 126 is provided to allow an operator to be alerted when certain preprogrammed parameters are exceeded. The microprocessor 122 records the parameters and sounds the alarm when they are exceeded. The audible alarm may comprise a piezoelectric alarm of any standard type.

The external alarm control 128 may be provided to allow connection to and control of a remote alarm. It may comprise an open collector circuit capable of sinking 1.0 amps DC, of any standard type.

The LCD display 134 is provided to allow visual display of the information which the microprocessor has calculated, such as important parameters of the input line signal. It may comprise an LCD display of any standard type.

The RS-232 port 136 may be provided to allow serial data communications with external devices. It may comprise a digital serial port of any standard type.

Signal Memory

The microprocessor 122 samples the square-wave signal from the frequency detector 114 by means of an input port(shown in the drawing as I/O ports 124). Because of the relatively long duration of each period of a roughly sixty-Hertz wave, the microprocessor is able to measure the time duration of each period with great accuracy and precision. The microprocessor may measure the line signal frequency over several preprogrammed periods of the input signal, then compare the measured frequency against certain alarm limits which have been preprogrammed.

The system clock 120 is referenceable by the microprocessor to obtain a time-of-day value to associate with each recordable frequency-measurement event. During normal operation the time of day clock is synchronised with the sixty-cycle line frequency, ie, every 60th cycle the microprocessor increments the time-of-day clock one second. On the other hand, during battery carryover the microprocessor keeps time by using a counter to count the 2.0 MHz clock pulses. When the counter accumulates two million counts, the time-of-day clock is incremented one second, as is well known in the art.

The operator is able to key in a high frequency alarm limit and a low frequency alarm limit; these values are stored in registers found in the microprocessors RAM memory 132, along with their associated time-of-day values. If the measured average frequency is found outside either of these alarm limits an audible alarm is triggered and the operator (if present) will know immediately. The microprocessor 122 also records the high frequency for the past twenty-four hours and the low frequency for the past twenty-four hours; these values are also stored in registers found in the microprocessor's RAM memory 132, along with their associated time-of-day values.

Human Interface

As noted above, the operator is able to key in alarm limits for the microprocessor 122 to record and remember. The operator is also able to key in other commands to the microprocessor through the keyboard 116. Commands which are entered from the keyboard are processed by the microprocessor under software control and used to perform immediate functions or to alter registers in RAM memory 132 for later control of its functions. Available operator commands are listed here:

The "SET TIME" command is used to enter a new time-of-day value for the system clock. The microprocessor 122 records this value in a register in its RAM memory 132.

The "SET ALARM FREQUENCY" command is used to enter new high frequency and low frequency alarm limits. The microprocessor 122 records these values in registers in its RAM memory 132.

The "SET FLASHING" command is used to direct the microprocessor 122 to display its data in a flashing mode when any alarm is generated. The microprocessor records this value in a register in its RAM memory 132.

The "MANUAL RESET OF HIGH-LOW FREQUENCY" command is used to reset the recorded high frequency and recorded low frequency values. The microprocessor resets these registers in its RAM memory 132.

The "AUTOMATIC RESET OF HIGH-LOW FREQUENCY" command is used to direct the microprocessor 122 to automatically reset the recorded high freequency and recorded low frequency to the present line frequency value. The microprocessor records the time when this is to occur in a register in its RAM memory 132. When this time is reached, the reset is automatically performed.

The "TEST AUDIO ALARM" command is used to direct the microprocessor to test its audio alarm.

The "SET SAMPLE RATE" command is used to set the input signal sample rate. The microprocessor records this value in a register in its RAM memory 132.

Power Supply

Referring now to Figure 2, the circuit for the power supply is disclosed.

The line signal 102 is collected via an ordinary wall plug 217, and input to the input filter 104, which comprises an inductor-capacitor circuit, forming a filter as is well-known in the art. A metal-oxide varistor (MOV) is used to protect against excess voltage. The filtered signal is then drawn to a power supply 106, which comprises a power transformer 202, controlled by a switch 218 to select between 120 volts AC and 240 volts AC.

The power transformer 202 comprises a primary coil 204 (of selectable length by a switch 218), a first secondary coil 206, a second secondary coil 208, and may comprise a soft iron core 203. The first secondary coil is wound to create a 24 volt AC signal from an input 120 volt AC or 240 volt AC; it is drawn to a full-wave bridge rectifier 210, a pair of regulators 220 and 222, and a capacitor network 212 of six capacitors to filter the DC output and remove ripple and noise, as is well known in the art. The output signal is drawn from the full-wave bridge rectifier and capacitor network to a pair of regulators providing a + 12 volt DC and -12 volt DC supply, as is well known in the art.

The second secondary coil is drawn to a full-wave rectifier 214, a regulator 224, and a capacitor network 216 of three capacitors to filter the DC output and remove ripple and noise, as is well known in the art. The output signal is drawn from the full-wave rectifier and capacitor network to a regulator providing a + 5 volt DC supply, as is well-known in the art. The power supply from the full-wave rectifier is also drawn to a battery carryover circuit 108, which allows the system to trickle charge the battery, as is well known in the art.

The battery carryover circuit 108 comprises a battery 302 connected in parallel with a zener diode 304. When power-loss is detected, the Darlington coupled transistor 306 switches on and supplies battery power to the circuitry.

It should be remembered that while a presently preferred embodiment of the present invention has been disclosed, variations are possible which remain within the scope of the present invention.

## Claims

1. A device for monitoring AC line signal frequency, characterised in that it comprises means - (114) for measuring the line signal frequency over a relatively short period of time, means (122) for comparing said measured frequency value against a pair of high and low recorded frequency values, means (132) for recording said measured frequency value when it falls outside the interval defined by said pair of high and low recorded frequency values, means (132) for recording a time of day value associated with each measured high and low recorded frequency value, and means (134) for displaying said recorded high and low frequency values, and their associated time of day values.

2. A device as claimed in claim 1 characterised in that said means (122) for comparing, both said means (132) for recording, and said means (134) for displaying, includes a microprocessor under software control.

3. A device as claimed in claim 1 or 2 characterised in that said high and low recorded frequency values are resettable by operator control.

4. A device for monitoring AC line signal frequency, characterised in that it comprises means - (114) for measuring the line signal frequency over a relatively short period of time, means (122) for comparing said measured frequency value against a pair of high and low alarm limit values, means - (132) for recording said measured frequency value when it falls outside the interval defined by said pair of high and low alarm limit values, means - (132) for recording a time of day value associated with each measured frequency value, and means - (134) for displaying said recorded frequency values which fall outside the interval defined by said pair of high and low alarm limit values, and their associated time of day values.

5. A device as claimed in claim 4, characterised in that said means (122) for comparing, both said means (132) for recording, and said means (134) for displaying, includes a microprocessor under software control.

6. A device as claimed in claim 4 or 5, characterised in that said high and low alarm limit values are settable by operator control.

7. A device for monitoring AC line signal frequency characterised in that it comprises means - (114) for measuring the line signal frequency over a relatively short period of time, means (122) for comparing said measured frequency value against a pair of high and low alarm limit values, and means (126) for generating an alarm signal when said measured frequency value falls outside the interval defined by said pair of high and low alarm limit values.

8. A device as claimed in claim 7, characterised in that said means (122) for comparing and said means (126) for generating are both a microprocessor under software control.

9. A device as claimed in claim 7 or 8, characterised in that the high and low alarm limit values are settable by operator control.

10. A method of monitoring AC line signal frequency, characterised in that it comprises the steps of measuring the average line signal frequency over a relatively short period of time, comparing said measured frequency value against a pair of high and low recorded frequency values, recording said measured frequency value when it falls outside the interval defined by said pair of high and low recorded frequency values, recording a time of day value associated with each measured frequency value, and displaying said recorded high and low freqeuncy values, and their associated time of day values.

11. A method as claimed in claim 10, characterised in that said step of comparing, both said steps of recording, and said step of displaying, are all carried out by a microprocessor under software control.

12. A method of monitoring AC line signal frequency, characterised in that it comprises the steps of measuring the line signal frequency over a relatively short period of time, comparing said measured frequency value against a pair of high and low alarm limit values, recording said measured frequency value when it falls outside the interval defined by said pair of high and low alarm limit values, recording a time of day value associated with each measured frequency value, and displaying said recorded frequency values which fall outside the interval defined by said pair of high and low alarm limit values, and their associated time of day values.

13. A method as claimed in claim 12 characterised in that said step of comparing, both said steps of recording, and said step of displaying, are all carried out by a microprocessor under software control.

14. A method of monitoring AC line signal frequency characterised in that it comprises the steps of measuring the line signal frequency value over a relatively short period of time, comparing said measured frequency value against a pair of high and low alarm limit values, and generating an alarm signal when said measured frequency value falls outside the interval defined by said pair of high and low alarm limit values.

15. A method as claimed in claim 14 characterised in that said step of comparing and said step of generating are both carried out by a microprocessor under software control.

16. A device for measuring the frequency of utility power supply signals, characterised in that it comprises Schmidt trigger circuit means (114) for converting the supply signal into a substantially square wave signal, clock means (120) for generating a digital clock signal of known frequency, means(122)for counting the number of pulses of said digital clock signal in a single cycle of the utility power supply signal, and means (122) for calculating the frequency of the utility power signal from the average of said count of pulses for a recent period of time.

17. A device as claimed in claim 2 characterised in that it includes means (112) for measuring line signal voltage and monitoring variations in such voltage beyond predetermined values.

18. A device as claimed in claim 2 characterised in that it includes means (112) for measuring the convenience outlet line signal voltage over a relatively short period of time.

19. A device as claimed in claim 2 characterised in that it includes printing means (400) for printing recorded high and low frequency values, and their associated time of day values.

20. A device as claimed in claim 18 characterised in that it includes printing means (400) for printing recorded high and low voltage values.

21. A device as claimed in claim 19 charaterised in that the printing means serves also for printing recorded convenience outlet voltage values.

22. A device as claimed in claim 2 characterised in that it includes alarm means (126) for signalling frequency values outside the interval defined by said pair of high and low recorded frequency values.

Fig. 1.

0 219 962

_FIG_2_

| Category | Citation of document with indication, where appropriate, of relevant passages | Relevant to claim | CLASSIFICATION OF THE APPLICATION (Int. Cl.4) |
|---|---|---|---|
| | **DOCUMENTS CONSIDERED TO BE RELEVANT** | | EP 86306926.6 |
| X | CA - A - 1 144 986 (CANADIN GENERAL ELECTRIC) <br><br> * Page 1, lines 11-18; page 3, lines 26-30 * <br><br> ---- | 1-22 | G 01 R 23/15 |

TECHNICAL FIELDS
SEARCHED (Int. Cl.4)

G 01 R 23/00
H 02 H  3/00

The present search report has been drawn up for all claims

| Place of search | Date of completion of the search | Examiner |
|---|---|---|
| VIENNA | 28-11-1986 | KUNZE |